# EUROPÄISCHE PATENTANMELDUNG

(11) **EP 1 693 958 A1**
(43) Veröffentlichungstag der Anmeldung: **23.08.2006**
(21) Anmeldenummer: 06001670.6
(22) Anmeldetag: 27.01.2006
(51) Int. Cl.: H03F 3/195, H03F 3/193, H03F 1/02, H03F 1/32

(54) **Verfahren zum Betrieb eines Hochfrequenzverstärkers**

(30) Priorität: 16.02.2005 DE 102005007159
(71) Anmelder: EADS Deutschland GmbH, 85521 Ottobrunn (DE)
(72) Erfinder: Hoffmann, Gebhard, 80805 München (DE); Salomon, Andreas, 85716 Unterschleissheim (DE); Huber, Georg, 85406 Zolling (DE)
(74) Vertreter: Meel, Thomas

(57) **Zusammenfassung**

Die Erfindung betrifft ein Verfahren zum Betrieb eines Hochfrequenzverstärkers umfassend einer in Source- bzw. Emitterschaltung ausgeführten Leistungstransistor-Verstärkerstufe (LT,1) zur Verstärkung von jeweils gate- bzw. basisseitig über ein Eingangsanpassungsnetzwerk (E) eingegebenen Hochfrequenzsignalen, die verstärkt drain- bzw. kollektorseitig über ein Ausgangsanpassungsnetzwerk (A) abgenommen werden, wobei an die Verstärkerstufe (1) drain- bzw. kollektorseitig eine Vorrichtung zur Messung des Drain- bzw. Kollektorstroms (I_D) und gate- bzw. basisseitig ein Regelglied (4) angeschlossen werden, welchem ein vorgebbarer Sollwert (W_SOLL) und ein dem Drain- bzw. Kollektorstrom (I_D) entsprechender Istwert (W_IST) zugeführt wird, wobei über das Regelglied (4) die Gatespannung bzw. der Basisstrom derart einstellt wird, dass der Drain- bzw. Kollektorstroms (I_D) dem Sollwert (W_SOLL) nachgeführt wird.

Erfindungsgemäß wird bei konstanter Eingangsleistung (P_IN) des Hochfrequenzverstärkers die Hüllkurve des Ausgangssignals (RF_OUT) durch den Sollwert (W_SOLL) moduliert.

## Beschreibung

Die Erfindung betrifft ein Verfahren zum Betrieb eines Hochfrequenzverstärkers gemäß dem Oberbegriff des Patentanspruchs 1.

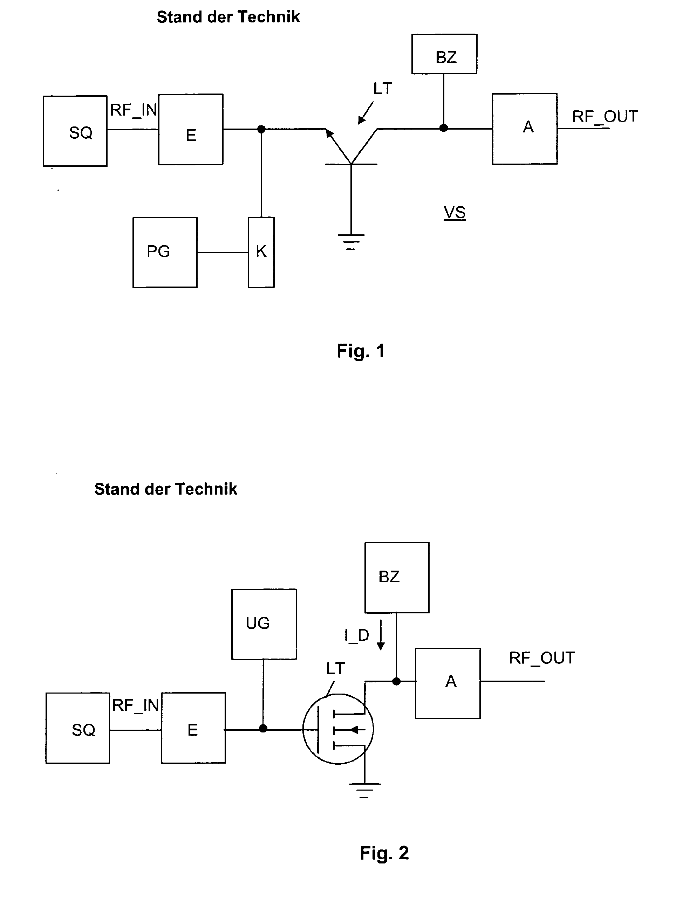

Aus DE 29 04 011 ist ein Hochfrequenzverstärker mit einer in Basisschaltung ausgeführten Leistungstransistor-Verstärkerstufe bekannt (Fig. 1). Emitterseitig ist ein Eingangsanpassungsnetzwerk E, welchem ein in einer Signalquelle SQ erzeugtes Eingangssignals RF_IN zugeführt ist, und kollektorseitig ein Ausgangsanpassungsnetzwerk A zur Ausgabe eines Ausgangssignals RF_OUT angeschlossen. Zusätzlich ist emitterseitig eine von einem Pulsgeber PG gesteuerte Konstantstromquelle K an die Verstärkerstufe VS angeschlossen, welche der Kollektor-Emitterstrecke des Leistungstransistors LT der Verstärkerstufe VS für die Dauer des Pulses einen dem Impulsverlauf entsprechenden Strom einprägt. Dadurch ist einerseits eine Einstellung der Sendeleistung und andererseits eine Modulation der HF-Hüllkurve möglich. Kollektorseitig ist eine Betriebsgleichspannungszuführung BZ für den Leistungstransistor LT vorgesehen.
Nachteilig ist allerdings, dass die in DE 29 04 011 angegebene Schaltung ausschließlich für Bipolartransistoren in Basisschaltung anwendbar sind. Des Weiteren erzeugt die verwendete Konstantstromquelle K prinzipbedingt eine große Verlustleistung.

Fig. 2 zeigt eine Schaltungsanordnung eines Linearverstärkers mit einem MOSFET-Leistungstransistor LT. Gateseitig ist ein Eingangsanpassungsnetzwerk E, welchem ein in einer Signalquelle SQ erzeugtes Eingangssignals RF_IN zugeführt ist, und drainseitig ein Ausgangsanpassungsnetzwerk A zur Ausgabe eines Ausgangssignals RF_OUT angeschlossen. Weiterhin ist gateseitig ein Spannungsgeber UG zur Arbeitspunkteinstellung des Leistungstransistors LT angeschlossen. Eine Stromquelle BZ ist drainseitig an den Leistungstransistor LT angeschlossen.
Ein Nachteil dieser Schaltungsanordnung ist die große Verlustleistung in Sendepausen oder beim Senden mit kleinen Leistungen. Ein weiterer Nachteil ist die thermische Abhängigkeit der Verstärkung, d.h. eine Temperaturveränderung des Leistungsverstärkers bewirkt eine entsprechende Änderung der Ausgangsleistung. Des Weiteren erweist sich der Schwellspannungsdrift bedingt durch die Alterung der Bauteile als nachteilig.
Ein weiterer Nachteil ist die ungenaue Sendeleistungseinstellung im dynamischen Betrieb der Verstärkerschaltung.

Aus DE 196 04 239 A1 ist ein Hochfrequenzverstärker nach dem Oberbegriff des Patentanspruchs 1 bekannt. Bei diesem Verstärker wird die Ausgangsleistung konstant gehalten, obwohl die Versorgungsspannung einer Batterie im Laufe des Betriebs geringer wird.

Aufgabe der Erfindung ist, ein Verfahren zum Betrieb eines Hochfrequenzverstärkers anzugeben, mit welchem die Verlustleistung sowie die Temperaturabhängigkeit der Verstärkung bei genauer Sendeleistungseinstellung verringert werden sowie die HF-Hüllkurve moduliert werden kann.

Diese Aufgabe wird mit dem Verfahren gemäß Patentanspruch 1 gelöst. Vorteilhafte Ausführungen der Erfindung sind Gegenstand von Unteransprüchen.

Erfindungsgemäß wird ein Hochfrequenzverstärker umfassend einer in Source- bzw. Emitterschaltung ausgeführten Leistungstransistor-Verstärkerstufe zur Verstärkung von jeweils gate- bzw. basisseitig über ein Eingangsanpassungsnetzwerk eingegebenen Hochfrequenzsignalen derart betrieben, dass die über das Eingangsanpassungsnetzwerk eingegebenen Hochfrequenzsignale verstärkt drain- bzw. kollektorseitig über ein Ausgangsanpassungsnetzwerk abgenommen werden, wobei an die Verstärkerstufe drain- bzw. kollektorseitig eine Vorrichtung zur Messung des Drain- bzw.

Kollektorstroms I_D und gate- bzw. basisseitig ein Regelglied angeschlossen wird, welchem ein vorgebbarer Sollwert W_SOLL und ein dem Drain- bzw. Kollektorstrom I_D entsprechender Istwert W_IST zugeführt wird, wobei über das Regelglied die Gatespannung bzw. der Basisstrom derart einstellt wird, dass der Drain- bzw. Kollektorstroms I_D dem Sollwert W_SOLL nachgeführt wird, wobei bei konstanter Eingangsleistung P_IN des Hochfrequenzverstärkers die Hüllkurve des Ausgangssignals RF_OUT durch den Sollwert W_SOLL moduliert wird.

Das erfindungsgemäße Verfahren ist für Hochfrequenzverstärker mit FET-Transistoren sowie für Hochfrequenzverstärker mit Bipolartransistoren geeignet. Im Weiteren betreffen die Bezeichnungen drain-, gate- oder sourceseitig die FET-Transistoren und die Bezeichnungen kollektor-, basis- oder emitterseitig die Bipolartransistoren.

Die Erfindung wird im Weiteren anhand von Zeichnungen näher erläutert. Es zeigen:
- Fig. 1: einen Schaltungsaufbau eines Hochfrequenzimpulsverstärkers gemäß dem Stand der Technik,
- Fig. 2: einen Schaltungsaufbau eines Linearverstärkers gemäß dem Stand der Technik,
- Fig. 3: einen beispielhaften Schaltungsaufbau eines Hochfrequenzverstärkers, welcher gemäß der Erfindung betrieben wird, in FET-Technologie,
- Fig. 4: beispielhaft für einen nach der Erfindung betriebenen Hochfrequenzverstärker ein Kennlinienfeld der Ausgangsleistung über der Eingangsleistung bei verschiedenen Drainströmen.

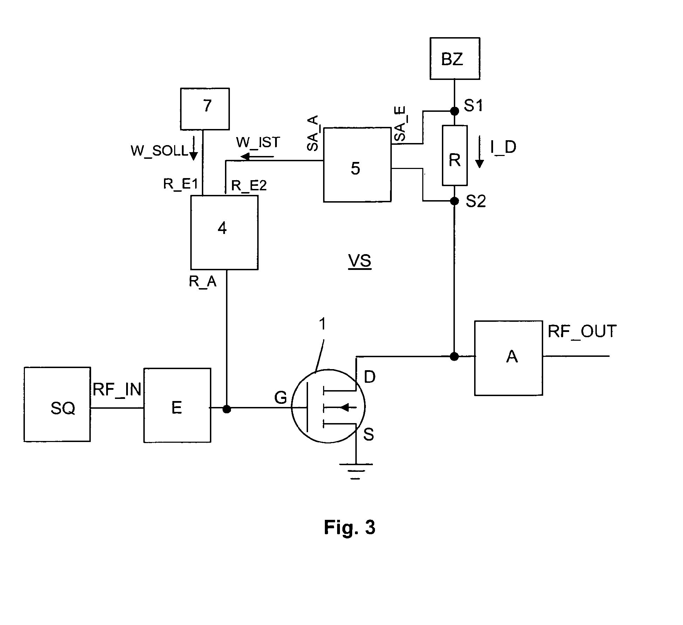

Fig. 3 zeigt einen beispielhaften Schaltungsaufbau eines Hochfrequenzverstärkers in, welcher gemäß der Erfindung betrieben wird, FET-Technologie, wobei es für einen Fachmann selbstverständlich ist, den Schaltungsaufbau auch in Bipolartechnologie zu realisieren.

Die Verstärkerstufe VS umfasst im Wesentlichen einen FET-Sendetransistor 1 mit daran angeschlossenen Eingangs- und Ausgangsanpassungsnetzwerken E, A sowie ein Regelglied 4, z.B. ein Regelverstärker, ein Signalanpassungsnetzwerk 5 und einen Widerstand R umfassenden geschlossenen Regelkreis.

Der FET-Sendetransistor 1 kann insbesondere ein LDMOS-, ein GaAs-MESFET- oder ein SiC-MESFET-Transistor sein. Der Gate-Anschluß G des Transistors 1 ist mit einem Eingangsanpassungsnetzwerk E verbunden, welchem das in einer Signalquelle SQ erzeugten, zu verstärkende RF-Signal RF_IN zugeführt wird. Der Source-Anschluß S des Transistors 1 ist mit Masse verbunden. Der Drain-Anschluß D des Transistors 1 ist mit einem Ausgangsanpassungsnetzwerk A verbunden, an welchem das verstärkte RF-Signal RF_OUT abgenommen wird.

Der Drain-Anschluß D des Transistors 1 ist vorteilhaft über einen Widerstand R mit der Spannungsquelle BZ verbunden. Der Widerstand R dient dazu, den Drainstrom I_D zu messen. Hierzu sind die Anschlüsse S1, S2 des Widerstands R mit einem Signalanpassungsnetzwerk 5 verbunden. Zweckmäßig ist die Dimension des Widerstands R derart gewählt, dass nur eine geringe Verlustleistung am Widerstand R auftritt.

Das zwei Eingänge R_E1, R_E2 umfassende Regelglied 4 ist mit seinem Ausgang R_A mit dem Gate-Anschluß G des Transistors 1 verbunden. Der eine Eingang R_E1 des Regelglieds 4 ist mit einer Einrichtung 7 verbunden, welche das Regelglied 4 mit einem vorgebbaren Sollwert W_SOLL versorgt. Der andere Eingang R_E2 des Regelglieds 4 erhält von dem Signalanpassungsnetzwerk 5 den Istwert W_IST, der dem Drainstrom I_D proportional ist. Das Signalanpassungsnetzwerk 5 bildet an seinem Ausgang SA_A den Drainstrom I_D, der durch den Widerstand R fließt, ab. Zu diesem Zweck ist das Signalanpassungsnetzwerk 5 mit den Anschlüssen S1, S2 des Widerstandes verbunden.

Die Einrichtung 7 kann in einer vorteilhaften Ausführung der Erfindung ein Impulsgeber sein. Dadurch werden dem Regelglied 4 Pulse mit einem vorgebbaren Amplitude und einer vorgebbaren Impulsform zugeführt. Dadurch ist es möglich, die Hüllkurve des Ausgangssignals RF_OUT zu beeinflussen. Zweckmäßig lässt sich so eine Amplituden- oder Pulsmodulation des Ausgangssignals RF_OUT erreichen. Bei der Pulsmodulation lässt sich insbesondere durch die Einstellung der Anstiegs- und Abfallzeiten der einzelnen Pulse die spektrale Breite des Spektrums des Ausgangssignals RF_OUT begrenzen.

Der erfindungsgemäße Hochfrequenzverstärker zeichnet sich insbesondere dadurch aus, dass in Sendepausen, d.h. die vom Regelglied 4 gelieferte Gatespannung sperrt den Transistor 1, keine Leistung aus der Spannungsquelle BZ aufgenommen wird. Hieraus ergeben sich weitere Vorteile hinsichtlich eines günstigen Wirkungsgrades, welcher insbesondere näherungsweise unabhängig von der eingestellten Ausgangsleistung P_OUT ist.

Die Wirkungsweise des Hochfrequenzverstärkers ist dabei wie folgt:

Dem Regelglied 4 wird an seinem Eingang R_E1 ein extern vorgebbarer Sollwert W_SOLL zugeführt. Der tatsächliche Drainstrom I_D wird über den Widerstand R gemessen und in dem Signalanpassungsnetzwerk 5 in einen proportionalen Istwert W_IST umgesetzt, welcher dem Regelglied 4 am Eingang R_E2 zugeführt ist. Durch Veränderung der Gatespannung des Transistors 1 am Ausgang R_A führt das Regelglied 4 den Drainstrom-Istwert W_IST dem Drainstrom-Sollwert W_SOLL nach, da eine Veränderung der Gatespannung zu einer Veränderung des Drainstroms I_D führt, was wiederum eine Veränderung der am Widerstand R abgegriffenen Spannung bewirkt.

Mit der Verstärkerschaltung wird der Drainstrom I_D unabhängig von der Eingangsleistung des Eingangssignals RF_IN konstant gehalten. Über den extern vorgegebenen Sollwert R_E1 wird die Leistung des Ausgangssignals RF_OUT innerhalb der durch die Verstärkung des Transistors 1 gegebenen Grenzen eingestellt. Somit ist die Sendeleistung (=Ausgangsleistung) einstellbar und kann den entsprechenden Erfordernissen dynamisch angepasst werden.

Ein weiterer Vorteil des Hochleistungsverstärkers ist die hohe Leistungsstabilität bei Schwankungen in der Eingangsleistung P_IN oder der Temperatur. Darüber hinaus zeigt der Hochleistungsverstärker eine hohe Leistungsstabilität bei einer Drift der Schwellspannung des verwendeten Leistungstransistors. Eine Drift der Schwellspannung ist insbesondere auf die Alterung der Bauelemente zurückzuführen.

Der Hochleistungsverstärker kann zweckmäßig in phasen- oder frequenzmodulierten Systemen Anwendung finden, bei denen eine konstante Amplitude über ein Sendetelegramm erfordert wird, z.B. in Systemen der Telekommunikation, insbesondere Handys, oder in Radargeräten oder in Systeme der Unterhaltungselektronik.

Eine weitere erfindungsgemäße Anwendung sind lineare Polar-Verstärker, bei denen die Phaseninformation in der Signalquelle SQ und die Amplitudeninformation im Leistungsverstärker moduliert ist. So lassen sich Linearverstärker mit hohem Wirkungsgrad realisieren wie sie z.B. für die neue Generation von Software Defined Radio (SDR) erforderlich sind.

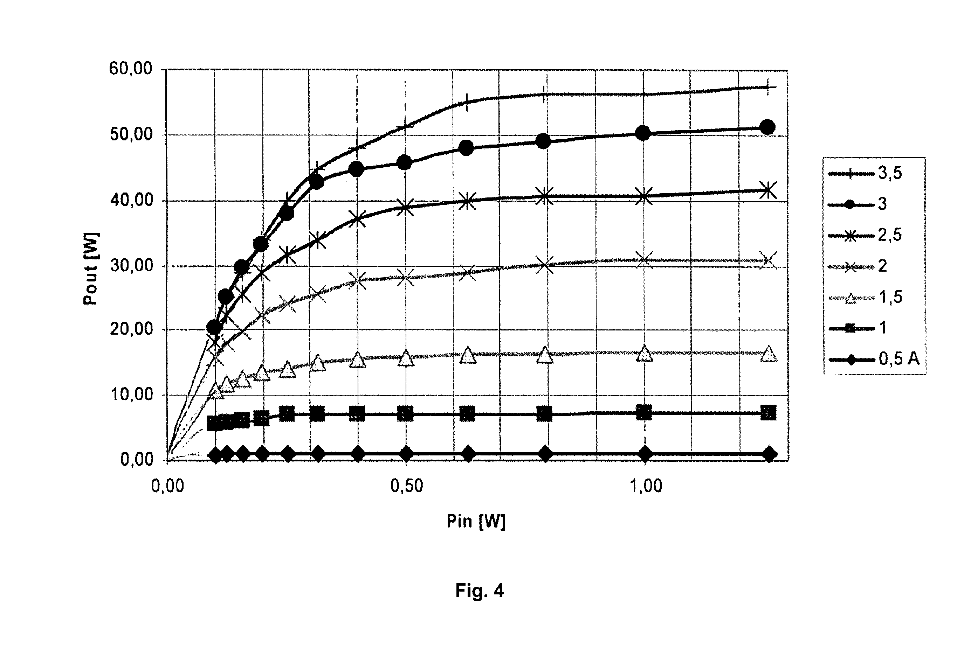

Fig. 4 zeigt beispielhaft für einen nach dem erfindungsgemäßen Verfahren betrieben Hochfrequenzverstärker ein Kennlinienfeld der Ausgangsleistung P_OUT über der Eingangsleistung P_IN bei verschiedenen Drainströmen. Die Darstellung zeigt, dass die Ausgangsleistung P_OUT in einem weiten Bereich nahezu unabhängig von der Eingangsleistung P_IN konstant gehalten werden kann. Die Ausgangsleistung P_OUT lässt sich über den Parameter Drainstrom I_D einstellen.
Aus der Darstellung wird deutlich, dass sich bei kleinen Eingangsleistungen P_IN und/oder großem Drainstrom I_D der Hochfrequenzverstärker wie ein Klasse A-Verstärker verhält, bei welchem die Ausgangsleitung P_OUT linear der Eingangsleistung P_IN folgt.
Die Ausgangsleistung P_OUT wird konstant gehalten, so lange die Eingangsleistung P_IN größer ist als die um die Verstärkung des Transistors verminderte Ausgangsleistung.

## Patentansprüche

1. Verfahren zum Betrieb eines Hochfrequenzverstärkers umfassend einer in Source- bzw. Emitterschaltung ausgeführten Leistungstransistor-Verstärkerstufe (LT, 1) zur Verstärkung von jeweils gate- bzw. basisseitig über ein Eingangsanpassungsnetzwerk (E) eingegebenen Hochfrequenzsignalen, die verstärkt drain- bzw. kollektorseitig über ein Ausgangsanpassungsnetzwerk (A) abgenommen werden, wobei an die Verstärkerstufe (1) drain- bzw. kollektorseitig eine Vorrichtung zur Messung des Drain- bzw. Kollektorstroms I_D und gate- bzw. basisseitig ein Regelglied (4) angeschlossen werden, welchem ein vorgebbarer Sollwert W_SOLL und ein dem Drain- bzw. Kollektorstrom I_D entsprechender Istwert W_IST zugeführt wird, wobei über das Regelglied (4) die Gatespannung bzw. der Basisstrom derart einstellt wird, dass der Drain- bzw. Kollektorstroms I_D dem Sollwert W_SOLL nachgeführt wird,
**dadurch gekennzeichnet, dass**
bei konstanter Eingangsleistung P_IN des Hochfrequenzverstärkers die Hüllkurve des Ausgangssignals RF_OUT durch den Sollwert W_SOLL moduliert wird.

2. Verfahren nach Anspruch 1, wobei mittels eines Impulsgebers (7) dem Regelglied (4) Pulse mit vorgebbarer Amplitude und Impulsform zugeführt werden.

3. Verfahren nach Anspruch 1 oder 2 zur Realisierung linearer Polar-Verstärker, bei denen die Phaseninformation in der Signalquelle (SO) und die Amplitudeninformation im Hochfrequenzverstärker (VS) moduliert wird, wobei der Sollwert W_SOLL entsprechend der Amplitudeninformation eingestellt wird.

4. Verwendung eines Verfahrens gemäß einem der vorangehenden Ansprüche in Telekommunikationsgeräten, Radargeräten oder Datenverarbeitungsgeräten.

## Geänderte Patentansprüche

### Geänderte Patentansprüche gemäss Regel 86(2) EPÜ.

**1.** Verfahren zum Betrieb eines Hochfrequenzverstärkers umfassend einer in Source- bzw. Emitterschaltung ausgeführten Leistungstransistor-Verstärkerstufe (LT, 1) zur Verstärkung von jeweils gate- bzw. basisseitig über ein Eingangsanpassungsnetzwerk (E) eingegebenen Hochfrequenzsignalen, die verstärkt drain- bzw. kollektorseitig über ein Ausgangsanpassungsnetzwerk (A) abgenommen werden, wobei an die Verstärkerstufe (1) drain- bzw. kollektorseitig eine Vorrichtung zur Messung des Drain- bzw. Kollektorstroms I_D und gate- bzw. basisseitig ein Regelglied (4) angeschlossen werden, welchem ein vorgebbarer Sollwert W_SOLL und ein dem Drain- bzw. Kollektorstrom I_D entsprechender Istwert W_IST zugeführt wird, wobei über das Regelglied (4) die Gatespannung bzw. der Basisstrom derart einstellt wird, dass der Drain- bzw. Kollektorstroms I_D dem Sollwert W_SOLL nachgeführt wird,
**dadurch gekennzeichnet, dass**
die Eingangsleistung P_IN des Hochfrequenzverstärkers konstant gehalten und die Hüllkurve des Ausgangssignals RF_OUT durch den Sollwert W_SOLL moduliert wird.
